# EUROPEAN PATENT APPLICATION

(11) **EP 4 439 677 A1**
(43) Date of publication of application: **02.10.2024**
(21) Application number: 24315107.3
(22) Date of filing: 26.03.2024
(51) Int. Cl.: H01L 29/778, H01L 21/337, H01L 29/10, H01L 29/41, H01L 29/20

(54) **HEMT DEVICE HAVING AN IMPROVED GATE STRUCTURE AND MANUFACTURING PROCESS THEREOF**

(30) Priority: 27.03.2023 IT 202300005811
(71) Applicant: STMicroelectronics International N.V., 1228 Plan-les-Ouates, Geneva (CH)
(72) Inventor: Iucolano, Ferdinando, 95030 GRAVINA DI CATANIA (CT) (IT); Chini, Alessandro, 41126 MODENA (IT); Castagna, Maria Eloisa, 95123 CATANIA (IT); Constant, Aurore, 37100 TOURS (FR); Tringali, Cristina, 96011 AUGUSTA (SR) (IT)
(74) Representative: Studio Torta S.p.A.

(57) **Abstract**

The HEMT device (20) has a body (22) including a heterostructure (25) configured to generate a 2-dimensional charge-carrier gas (30, 49); and a gate structure (33) which extends on a top surface (22A) of the body and is biasable to electrically control the 2-dimensional charge-carrier gas. The gate structure has a channel modulating region (40) of semiconductor material; a functional region (41) of semiconductor material; and a gate contact region (42) of conductive material. The functional region and the gate contact region extend on a top surface (40A) of the channel modulating region and the gate contact region is arranged laterally with respect to the functional region. The channel modulating region (40) has a different conductivity type with respect to the functional region (41).

## Description

### Technical Field

The present invention relates to a High Electron Mobility Transistor (HEMT) device having an improved gate structure and to the manufacturing process thereof.

### Background

HEMT devices are known wherein a conductive channel is based on the formation of high mobility 2-Dimensional Electron Gas (2DEG) layers at a heterojunction, i.e. at the interface between semiconductor materials with different bandgap. For example, HEMT devices based on the heterojunction between a layer of aluminum gallium nitride (AlGaN) and a layer of gallium nitride (GaN) are known.

HEMT devices based on AlGaN/GaN heterojunctions or heterostructures offer several advantages that make them particularly suitable and widely used for different applications. For example, the high breakdown threshold of HEMT devices is exploited for high-performance power switches; the high mobility of the electrons in the conductive channel allows high-frequency amplifiers to be provided; furthermore, the high concentration of electrons in the 2DEG allows a low ON-state resistance (R_{ON}) to be obtained.

Furthermore, HEMT devices for radio frequency (RF) applications typically have better RF performances with respect to similar silicon LDMOS devices.

HEMT devices based on AlGaN/GaN heterojunctions are normally depletion-mode, i.e. they are normally-on.

However, in different applications enhancement-mode, i.e. normally-off, GaN/AlGaN HEMTs are required, to improve the reliability of electronic devices, to reduce the design complexity of the drive circuits of the HEMT device and to reduce its power consumption.

Numerous approaches to achieve a normally-off HEMT device have been proposed, such as forming recessed gate structures, performing specific manufacturing steps including incorporating fluorine plasma under the gate structure, and forming p-GaN gate regions.

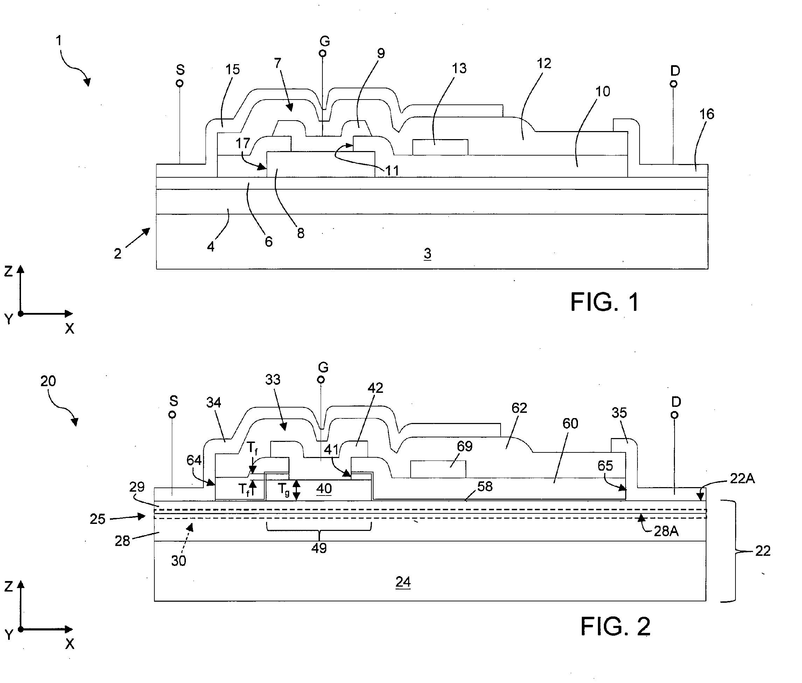

Figure 1 shows a known HEMT device 1 comprising a semiconductor body 2 having a substrate 3 of semiconductor material, a channel layer 4 of GaN and a barrier layer 6 of AlGaN overlying on each other.

The channel layer 4 and the barrier layer 6 are of N-type.

A gate structure 7 extends on the barrier layer 6. The gate structure 7 comprises a channel modulating region 8 of p-GaN and a gate contact region 9 of conductive material, for example a stack of TiN/AlCu/TiN.

The channel modulating region 8 extends on the barrier layer 6 and the gate contact region 9 extends on the channel modulating region 8.

A first insulating region 10, for example of silicon oxide, extends on the barrier layer 6, on lateral surfaces of the channel modulating region 8 and partially on a top surface of the channel modulating region 8.

An opening 11 extends, along an axis Z, through the first insulating region 10 and the gate contact region 9 extends into the opening 11.

A second insulating region 12, for example of silicon oxide, extends on the first insulating region 9 and on the gate contact region 9.

A field plate region 13, of conductive material, extends on the first insulating region 10, laterally to the gate contact region 9, and under the second insulating region 12.

A source region 15, of conductive material, extends on the barrier layer 6, on a first side of the gate structure 7 along an axis X, and partially on the second insulating region 12.

A drain region 16, of conductive material, extends on the barrier layer 6, on a second side of the gate structure 7 along the axis X, and partially on the second insulating region 12.

In use, the HEMT device 1 is of normally-off type. A positive voltage applied to the gate structure 7 causes the formation of a 2-dimensional electron layer (2DEG) below the channel modulating region 8, at the interface between the channel layer 4 and the barrier layer 6, and therefore the switch-on of the HEMT device 1.

The HEMT device 1 is subject, in the presence of the positive voltage, to a leakage current which flows through the gate structure 7 of the HEMT device 1, from the gate contact region 9 towards the 2DEG.

The leakage current may cause malfunctions of the HEMT device 1.

For example, the leakage current may cause a shift of the switch-on threshold voltage of the HEMT device 1, i.e. the voltage at which the 2DEG forms below the channel modulating region 8, with respect to the design value.

The leakage current has a bulk-type contribution and a parasitic-type contribution.

The bulk-type contribution is mainly affected by the concentration of doping species, for example magnesium atoms, of the channel modulating region 8; and by defects present at the interface between the channel modulating region 8 and the gate contact region 9, for example caused by partial removal or high roughness of the channel modulating region 8, originated during the manufacturing of the gate contact region 9.

The parasitic contribution originates from the top surface and from the lateral sidewalls 17 of the channel modulating region 8.

In fact, the lithography and etching processes used during the manufacturing step to pattern the channel modulating region 8, cause the formation of defects on the lateral sidewalls 17.

Such defects may lead to the formation of holes, for example holes of nitrogen atoms, wherein a high concentration of electrons is trapped.

This leads to the formation of a current path for the gate leakage current through the lateral sidewalls 17 of the channel modulating region 8.

The aim of the present invention is to overcome the disadvantages of the prior art.

### Summary

According to the present invention a HEMT device and a manufacturing process thereof are therefore provided, as defined in the attached claims.

### Brief Description of the Drawings

For a better understanding of the present invention, embodiments thereof are now described, purely by way of non-limiting example, with reference to the attached drawings, wherein:
- Figure 1 shows a cross-section of a known HEMT device;
- Figure 2 shows a cross-section of the present HEMT device, according to an embodiment;
- Figure 3 shows an enlarged portion of the HEMT device of Figure 2;
- Figure 4 shows an enlarged portion of the present HEMT device, according to a different embodiment;
- Figures 5A-5H show cross-sections of the HEMT device of Figure 3, in subsequent manufacturing steps; and
- Figure 6 shows a cross-section of the present HEMT device, according to a further embodiment.

### Description of Embodiments

The following description refers to the arrangement shown in the attached figures; consequently, expressions such as "above", "below", "lower", "upper", "right", "left", "top", "bottom", and the like, relate to the attached Figures and are not to be interpreted in a limiting manner.

Figure 2 shows a HEMT device 20 in a Cartesian reference system XYZ comprising a first axis X, a second axis Y and a third axis Z.

The HEMT device 20 is formed in a body 22 having a top surface 22A and comprising a substrate 24 and a heterostructure 25 extending on the substrate 24.

The substrate 24 may be formed by one or more layers of silicon, silicon carbide, gallium nitride (GaN), sapphire (Al₂O₃) or other materials.

In the embodiment of Figure 2, the substrate 24 is of semiconductor material.

In detail, the substrate 24 may comprise, although not shown separately in Figure 2, a substrate layer, for example of silicon or silicon carbide, and a buffer layer, for example of GaN, extending on the substrate layer. In this case, the buffer layer extends between the substrate layer and the heterostructure 25, to allow the growth of the heterostructure during the manufacturing of the HMET device 20.

The heterostructure 25 comprises compound semiconductor materials including elements of the groups III and V of the periodic table, extends on the substrate 24 and forms the top surface 22A of the body 22.

The heterostructure 25 comprises a channel layer 28 and a barrier layer 29 overlying on each other.

The channel layer 28 is of a first semiconductor material, for example gallium nitride (GaN) or an alloy comprising gallium nitride such as InGaN, here of gallium nitride (GaN), extends on the substrate 24 and has a top surface 28A.

The barrier layer 29 is of a second semiconductor material, for example a compound based on a ternary or quaternary gallium nitride alloy, such as AlₓGa₁₋ₓN, AlInGaN, InₓGa₁₋ₓN, AlₓIn₁₋ₓAl, AlScN, here of gallium nitride and aluminum (AlGaN), extending between the top surface 28A of the channel layer 28 and the top surface 22A of the body 22.

The channel layer 28 and the barrier layer 29 may be of intrinsic-, P- or N-type, depending on the specific application; in particular, both the channel layer 28 and the barrier layer 29 may be of N-type.

For example, when the barrier layer 29 is of AlGaN, the presence of aluminum atoms may cause the barrier layer 29 to be of N-type.

The heterostructure 25 is configured to accommodate a 2-dimensional gas (2DEG) of (movable) charge carriers, in particular here of electrons, identified by a dashed rectangle 30 in Figure 2.

In detail, in the embodiment of Figure 2, the 2-dimensional gas 30 is arranged at the interface between the channel layer 28 and the barrier layer 29, i.e. at the top surface 28A of the channel layer 28.

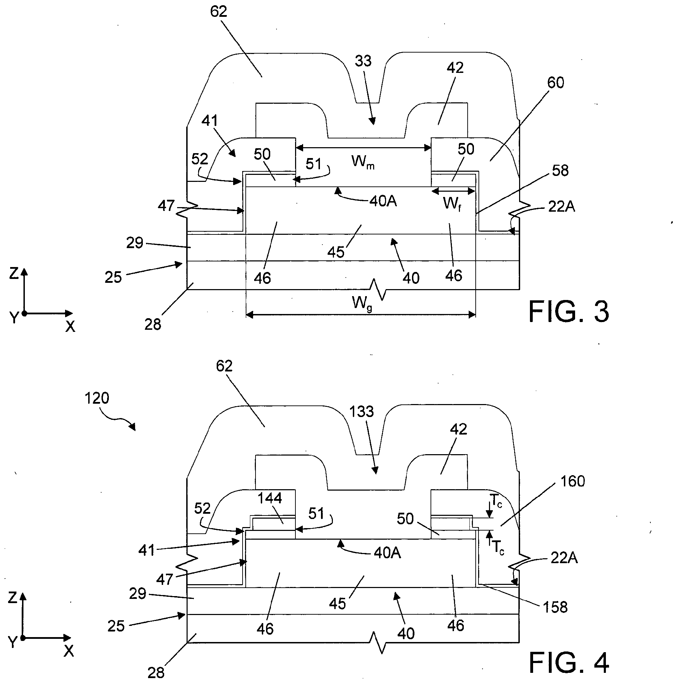

The HEMT device 20 comprises a gate structure 33 (shown in detail in Figure 3), a source region 34 and a drain region 35 respectively forming a gate electrode G, a source electrode S and a drain electrode D of the HEMT device 20.

The gate structure 33 extends on the top surface 22A of the body 22, in particular here in contact with the heterostructure 25, and is biasable to electrically control the formation of the 2-dimensional gas 30.

The gate structure 33 comprises a channel modulating region 40 of semiconductor material having a top surface 40A; a functional region 41 of semiconductor material; and a gate contact region 42 of conductive material, in electrical and physical contact with each other.

The channel modulating region 40 is of a compound material including elements of the groups III and V of the periodic table, for example it may be of gallium nitride (GaN) or of an alloy comprising gallium nitride, in particular here it is of GaN, and extends on the top surface 22A of the body 22.

In particular, in this embodiment, the modulating region 40 is in direct contact with the barrier layer 29.

The channel modulating region 40 has a thickness T_{g}, along the third axis Z, comprised for example between 30 nm and 150 nm, in particular of about 100 nm, and a width W_{g}, along the first axis X, comprised for example between 0.5 µm and 2 µm.

For example, the width W_{g} may be chosen, at the design stage, as a function of a maximum voltage that may be applied, in use, to the gate terminal G. For example, the higher the maximum voltage, the greater the width W_{g} may be chosen.

The channel modulating region 40 extends, in a manner not shown here, for example in the form of a strip elongated along the second axis Y.

In detail, the channel modulating region 40 comprises a central portion 45 arranged, parallel to the first axis X, between two peripheral portions 46.

The channel modulating region 40 may comprise, in a manner not shown here, further peripheral portions which extend at a distance from each other parallel to the second axis Y. The central portion 45 is arranged, parallel to the second axis Y, between the two further peripheral portions. In practice, the peripheral portions 46 may be joined together and form a single peripheral portion delimiting an external perimeter of the channel modulating region 40.

The peripheral portions 46 form lateral sidewalls 47 of the channel modulating region 40.

The central portion 45 and the peripheral portions 46 form, respectively, a central portion and peripheral portions of the top surface 40A of the channel modulating region 40.

The channel modulating region 40 has a different conductivity type with respect to the barrier layer 29, such that the channel modulating region 40 and the barrier layer 29 form a junction, in particular here a pn junction.

In this embodiment, the channel modulating region 40 is of P-type and has a concentration of doping species, for example magnesium atoms, comprised for example between 10¹⁸ and 10²⁰ atoms/cm³, in particular of about 2.10¹⁹ atoms/cm³.

The channel modulating region 40 is designed to modulate the formation of the 2-dimensional gas 30 based on a voltage applied to the gate electrode G.

In detail, the channel modulating region 40 controls the formation of the 2-dimensional gas 30 in a portion 49 of the heterostructure 25 arranged, parallel to the third axis Z, at the channel modulating region 40, in particular vertically aligned therewith.

In the embodiment shown, the channel modulating region 40 causes, in the absence of a voltage applied to the gate contact region 42, or with zero applied voltage, the portion 49 of the heterostructure 25 to be depleted of charge carriers, i.e. such that the 2-dimensional layer 30 is interrupted at the portion 49.

In practice, the HEMT device 20 is of normally-off type.

The functional region 41 is of a compound material including elements of the groups III and V of the periodic table, for example it may be of gallium nitride (GaN) or of an alloy comprising gallium nitride, and extends on the top surface 40A of the channel modulating region 40, in particular here in direct contact therewith.

The functional region 41 may be of the same material as the channel modulating region 40 or of a different material; in this embodiment of the same material, in particular of GaN.

The functional region 41 is designed to form a junction with the channel modulating region 40.

The functional region 41 has a different conductivity type with respect to the channel modulating region 40.

In detail, according to one embodiment, the functional region 41 may be of intrinsic type, i.e. it has a zero concentration of doping species, for example of intrinsic GaN.

According to a different embodiment, the functional region 41 may have an opposite conductivity type, i.e. here it may be of N-type, with respect to the conductivity type of the channel modulating region 40. For example, the functional region 41 may be of N-type GaN. For example, the functional region 41 may have a concentration of doping atoms, for example Silicon atoms, comprised between 10¹² and 10¹⁵ atoms/cm³. A concentration of doping species of the functional region 41 lower than 10¹⁵ atoms/cm³ may favor the electric insulation effect of the functional region 41 discussed hereinafter.

The functional region 41 has a thickness T_{f}, parallel to the third axis Z, comprised for example between 5 nm and 50 nm, in particular of about 30 nm.

In detail, in this embodiment, the functional region 41 is formed by portions 50, each having an inner wall 51 and an outer wall 52, each extending on a respective peripheral portion 46 of the channel modulating region 40.

The portions 50 of the functional region 41 are joined together, in a manner not shown here, so as to form a ring structure, for example of circular, polygonal or any other shape, for example depending on the shape of the underlying channel modulating region 40.

However, the portions 50 may be separated from each other.

The portions 50 each have a width W_{f}, parallel to the first axis X, smaller than the width W_{g}. For example, the width W_{f} may be comprised between 20 nm and 200 nm.

The portions 50 here extend throughout the width, parallel to the first axis X, of the peripheral portions 46 of the channel modulating region 40.

In other words, in this embodiment, the outer walls 52 of the portions 50 form an extension of the lateral sidewalls 47 of the channel modulating region 40, in particular are vertically aligned therewith.

The gate contact region 42, for example a multilayer of Ti/AlCu/TiN, extends on the top surface 40A of the channel modulating region 40, in particular here in direct contact therewith.

The gate contact region 42 forms a first Schottky contact with the channel modulating region 40.

The first layer (here not shown explicitly) of the gate contact region 42, for example Ti, TiN, Ta, TiW, TaW, in contact with the channel modulating region 40, may have a thickness comprised for example between 10 nm and 50 nm, in particular greater than 30 nm, so as to promote the formation of the electric contact.

The gate contact region 42 extends in direct contact also with the functional region 41.

In detail, the gate contact region 42 extends on the central portion 45 of the channel modulating region 40 in contact with the inner walls 51 of the portions 50 of the functional region 41.

In other words, the gate contact region 42 is arranged laterally adjacent, parallel to the first axis X in Figures 2 and 3, with respect to the functional region 41.

The gate contact region 42 may form an ohmic contact or a second Schottky contact with the functional region 41, depending on the specific doping level of the functional region 41 and on the specific material of the gate contact region 42 in contact with the functional region 41.

In case of Schottky contact, due to the different conductivity type between the functional region 41 and the channel modulating region 40, the second Schottky contact has a Schottky barrier, at equilibrium, having different height, in particular a smaller height, with respect to the Schottky barrier of first Schottky contact.

The gate contact region 42 has a width Wₘ, parallel to the first axis X, smaller than the width W_{g}.

According to one embodiment, the widths Wₘ and W_{f} may be chosen, at the design stage, so as to maximize the ratio Wₘ/W_{f}, i.e. to maximize the contact surface between the gate contact region 42 and the channel modulating region 40, for example so that each width W_{f} is smaller than 200 nm. In this manner, it is possible to obtain a homogeneous biasing of the entire channel modulating region 40.

A passivation layer 58, of insulating material, for example an oxide, in particular aluminum oxide (Al₂O₃), extends on portions of the top surface 22A of the body 22 laterally to the channel modulating region 40, between the source region 34 and the channel modulating region 40 and between the drain region 35 and the channel modulating region 40.

The passivation layer 58 also extends on the lateral sidewalls 47 of the channel modulating region 40 and on the outer walls 52 of the functional region 41.

In this embodiment, the passivation layer 58 also extends on the functional region 41, in contact therewith.

The passivation layer 58 has a thickness comprised for example between 2 nm and 10 nm, in particular of about 5 nm.

A first insulating layer 60, for example of silicon oxide or silicon nitride, extends on the passivation layer 58.

The gate contact region 42 extends through the passivation layer 58 and the first insulating layer 60 and partially on the first insulating layer 60.

A second insulating layer 62, for example of silicon oxide or silicon nitride, extends on the first insulating layer 60 and on the gate contact region 42.

The passivation layer 58 and the first and the second insulating layers 60, 62 form two openings 64, 65 extending on two opposite sides of the gate structure 33, parallel to the first axis X, which expose the top surface 22A of the body 22.

The source region 34 is of a conductive material, for example of Ti/AlCu/TiN, and extends, within the opening 64, on the top surface 22A of the body 22, in contact with the barrier layer 29.

In the embodiment of Figure 2, the source region 34 also comprises a portion which extends on the second insulating layer 62, above the gate contact region 42, and which acts as an electromagnetic shield.

The HEMT device 20 may also comprise a field plate region 69 which extends between the first and the second insulating layers 60, 62, laterally and at a distance along the first axis X with respect to the gate contact region 42. In such a case, the source region 34 may also extend above the field plate region 69, also here again acting as a shield.

The drain region 35 is of conductive material, for example of Ti/AlCu/TiN, and extends, within the opening 65, on the top surface 22A of the body 22, in contact with the barrier layer 29.

The source region 34 and the drain region 35 form an electrical contact, in particular of ohmic type, with the heterostructure 25, in particular with the 2-dimensional gas 30. In practice, the source region 34 and the drain region 35 are current conducting regions of the HEMT device 20.

Depending on the specific application of the HEMT device 20 and the specific manufacturing process used to obtain the source region 34 and the drain region 35, the source region 34 and the drain region 35 may be in direct ohmic contact with the 2-dimensional gas 30 or may be in electrical contact with the 2-dimensional gas 30 through the barrier layer 29.

For example, according to one embodiment, the source region 34 and the drain region 35 may be of recess type, i.e. they may extend in whole or in part, parallel to the third axis Z, through the barrier layer 29. In this manner, the source region 34 and the drain region 35 may be in direct electrical contact with the 2-dimensional gas 30 and thus obtain a low contact resistance.

The HEMT device 20 allows improved performances to be obtained with regard to the gate leakage current which may originate from the lateral sidewalls 47 of the channel modulating region 40.

The presence of the functional region 41 on the top surface 40A of the channel modulating region 40 in fact causes the formation of a depleted region at the interface between the functional region 41 and the channel modulating region 40.

In practice, the depleted region, devoid of (movable) charge carriers, i.e. electrons and holes, is a region which electrically insulates the gate contact region 42 from the lateral sidewalls 47 of the channel modulating region 40.

Consequently, the fact that the gate contact region 42 is arranged laterally, parallel to the first axis X in Figures 2 and 3, with respect to the functional region 41 allows a high electrical insulation to be obtained between the gate contact region 42 and the lateral sidewalls 47.

Consequently, in on-state (voltage applied to the gate electrode G greater than zero), the HEMT device 20 has a low leakage current.

In particular, when the channel modulating region 40 and the functional region 41 have an opposite conductivity type, for example P- and N-conductivity type respectively, the electrical-insulation and leakage-current reduction effect may be greater with respect to the case in which the functional region 41 is of intrinsic type.

The fact that the gate contact region 42 is in contact with the functional region 41, in particular may be in ohmic contact therewith, causes that, when the HEMT device 20 is on (voltage applied to the gate electrode G greater than zero), the junction formed by the functional region 41 and the channel modulating region 40 is in a reverse bias condition. In this manner, the resulting depleted region prevents the flow of the lateral leakage current.

In addition, in the present embodiment, the presence of the passivation layer 58 which extends on the lateral sidewalls 47 of the channel modulating region 40 allows the formation of surface electronic states to be reduced on the lateral sidewalls 47, further contributing to the reduction of the leakage current.

In addition, the fact that the gate contact region 42 extends directly on the top surface 40A allows to obtain a Schottky junction with the channel modulating region 40 and to obtain a more effective biasing of the channel modulating region 40, with respect, for example, to the case in which the functional region 41 extends, parallel to the third axis Z, between the channel modulating region 40 and the gate contact region 42.

Figure 4 shows a portion of the present HEMT device, here indicated by 120, according to a different embodiment.

The HEMT device 120 has a general structure similar to that of the HEMT device 20 of Figure 2; consequently, Figure 4 shows only one portion of the HEMT device 120 which highlights the differences thereof with respect to the HEMT device 20.

The elements of the HEMT device 120 visible in Figure 4 which are in common with the HEMT device 20 are indicated by the same reference numerals and are not further described in detail.

Furthermore, although not shown, the HEMT device 120 also comprises a source region, a drain region, and a substrate, as discussed for the HEMT device 20.

The HEMT device 120 has a gate structure, here indicated by 133, which also here comprises the channel modulating region 40 with the respective portions 45, 46, the functional region 41 with the respective portions 50, and the gate contact region 42.

In this embodiment, the gate contact region 42 is a first gate contact region and the HEMT device 120 further comprises a second gate contact region 144, in direct electrical contact with the first gate contact region 42.

The second gate contact region 144 is of a conductive material, for example a single layer of Ti, TiN, Ta or TaN having a thickness comprised for example between 5 nm and 50 nm and extending on the functional region 41, in contact therewith. The second gate contact region 144 creates a barrier that may prevent the diffusion of contaminants.

The second gate contact region 144 is arranged adjacent, along the first axis X, to the first gate contact region 42.

The second gate contact region 144 is in ohmic or quasiohmic contact with the functional region 41, depending on the conductivity type and doping level of the functional region 41.

In particular, when the functional region 41 is of N-type, the second gate contact region 144 may be in ohmic contact with the functional region 41.

In detail, the second gate contact region 144 is formed by two portions each extending on a respective portion 50 of the functional region 41. These portions may be separated from each other or joined together, in a manner here not shown, for example based on the specific design layout and on the shape of the functional region 41.

The portions of the second gate contact region 144 may each have a width, parallel to the first axis X, smaller than or equal to, here smaller than, the portions 50 of the functional region 41.

The passivation layer, here indicated by 158, is of the same material as the passivation layer 58 of the HEMT device 20 and extends on the top surface 22A, the lateral sidewalls 47 of the channel modulating region 40 and the outer walls 52 of the functional region 41.

Furthermore, the passivation layer 158 extends partially over the portions 50 of the functional region 41, on outer walls of the second gate contact region 144 and on top of the second gate contact region 144.

The second insulating layer, here indicated by 160, for example of silicon oxide or silicon nitride, extends on the passivation layer 158, in contact therewith.

The HEMT device 120 has the same advantages discussed with reference to the HEMT device 20.

In addition, the presence of the second gate contact region 144 in contact, in particular if in ohmic or quasiohmic contact, here ohmic contact, with the functional region 41, allows a more accurate control of the behavior of the electric field in the peripheral portions 46 of the gate modulating region 40.

Consequently, the HEMT device 120 allows to accurately control the formation of the 2DEG 30 under the channel modulating region 40, throughout the respective width W_{g}.

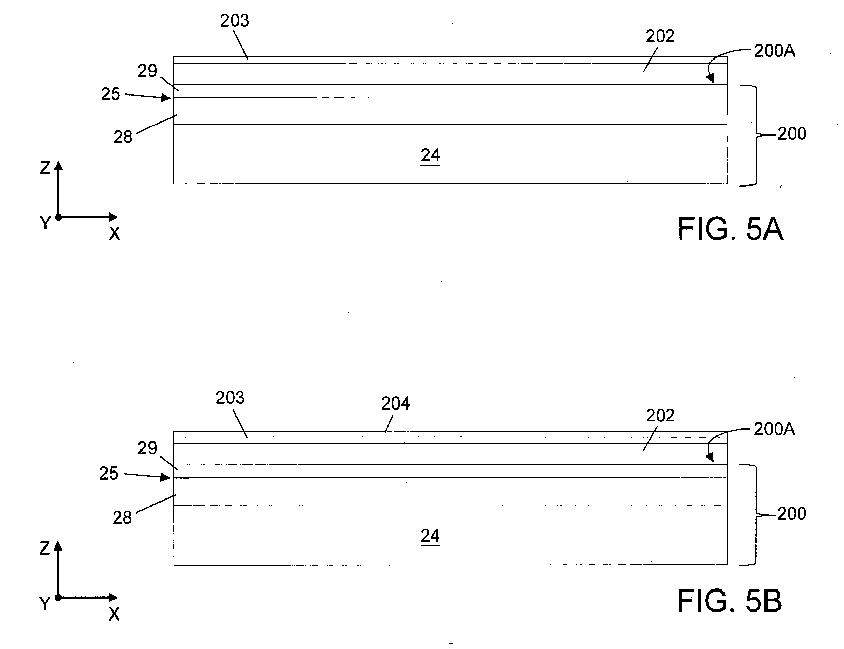

Hereinafter, with reference to Figures 5A-5H, manufacturing steps of the HEMT device 120 are described.

Figure 5A shows a cross-section of a work body 200 having a top surface 200A. Elements of the work body 200 common to what has already been described with reference to Figures 2 and 3 are indicated with the same reference numerals and are not further described in detail.

In the work body 200 the substrate 24 and the heterostructure 25 comprising the channel layer 28 and the barrier layer 29 have already been formed.

In this embodiment, the barrier layer 29 forms the top surface 200A of the work body 200.

Furthermore, a channel modulating layer 202 of semiconductor material and destined to form the channel modulating region 40, for example of P-type GaN, has been formed on the top surface 200A; and a functional layer of semiconductor material and destined to form the functional region 41, for example of intrinsic or N-type GaN, has been formed on the channel modulating layer 202.

For example, the layers 202, 203 are epitaxially grown by Metal-Organic Chemical Vapor Deposition (MOCVD).

Subsequently, Figure 5B, a contact layer 204 (destined to form the second gate contact region 144), for example a single layer of Ti, TiN, Ta, TaN, etc. or a multilayer, is formed on the functional layer 203.

The layers 202, 203, 204 may be deposited or grown without a mask, i.e. in blanket mode.

The work body 200 may be subject to annealing, so as to promote the formation of an ohmic contact between the contact layer 204 and the functional layer 203.

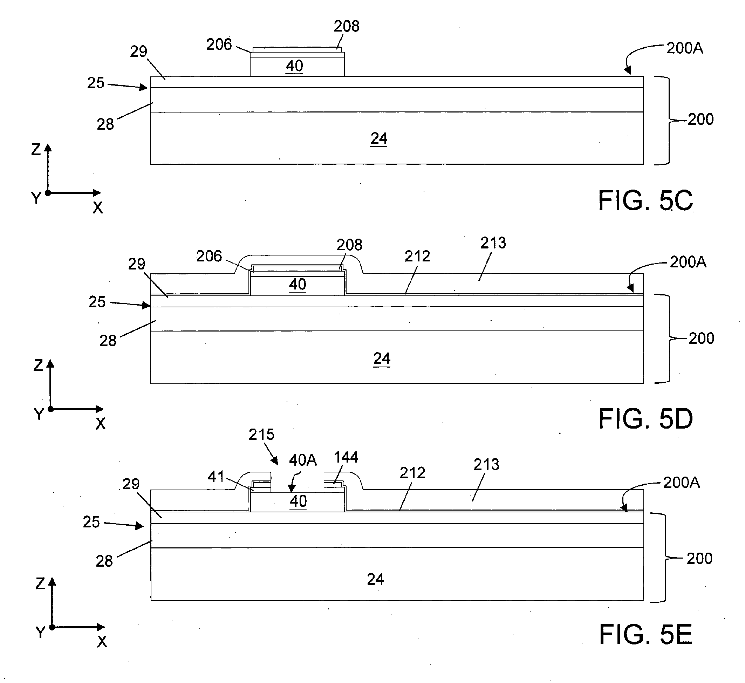

In Figure 5C, the layers 202, 203 and 204 are defined by lithography and etching steps. In practice, the channel modulating layer 202 is patterned so as to form the channel modulating region 40.

A residual portion 206, which extends on the channel modulating region 40, in particular throughout the respective top surface, remains from the functional layer 203.

A residual portion 208, which extends on the portion 206, remains from the contact layer 204.

Then, Figure 5D, a work passivation layer 212, for example an oxide, in particular Al₂O₃, destined to form the passivation layer 158, is formed without a mask on the front side of the work body 200.

In practice, the work passivation layer 212 covers the exposed portions of the top surface 200A, of the modulating region 40 and of the portions 206, 208.

For example, the work passivation layer 212 is formed by thermal or plasma Atomic Layer Deposition (ALD), in a water-based atmosphere at 300°C.

A first work insulating layer 213, for example of silicon oxide or silicon nitride, destined to form the first insulating layer 160, is formed without a mask on the work passivation layer 212.

Then, Figure 5E, a window 215 is opened through the first work insulating layer 213, the work passivation layer 212, and the portions 206, 208, so as to expose the portion of the top surface 40A of the channel modulating region 40 where it is intended to form the first gate contact region 42.

In practice, the second contact region 144 is formed from the residual portion 208 of the contact layer 204.

The functional region 41 of the gate structure 133 is formed from the residual portion 206 of the functional layer 203.

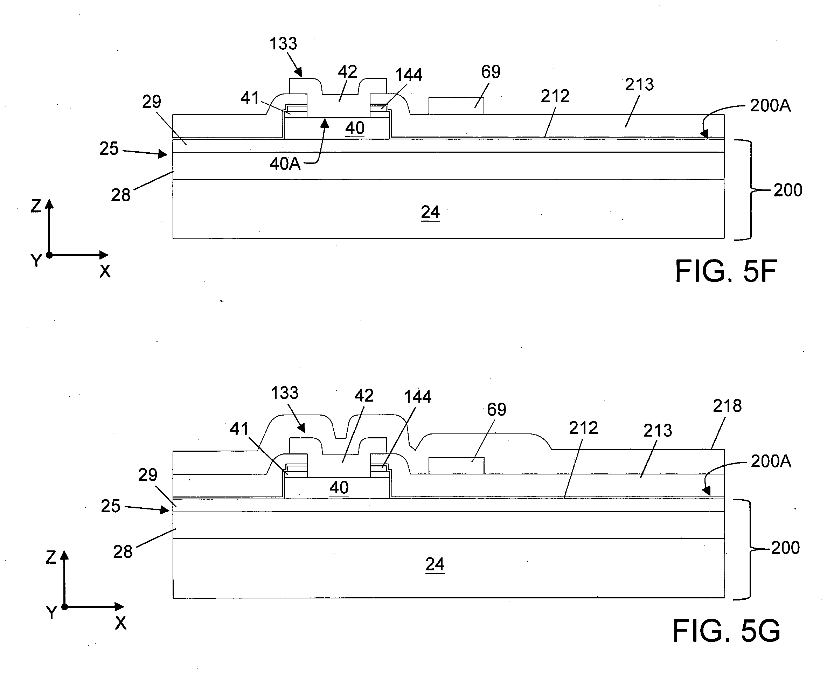

In Figure 5F, a work conductive region is deposited and patterned to form the first gate contact region 42 within the window 215 and, partially, on the second work insulating layer 213.

Furthermore, from the work conductive region, the field plate region 69 may also be formed.

Subsequently, Figure 5G, a second work insulating layer 218 is deposited on the first work insulating layer 213, the first gate contact region 42 and, if present, the field plate region 69.

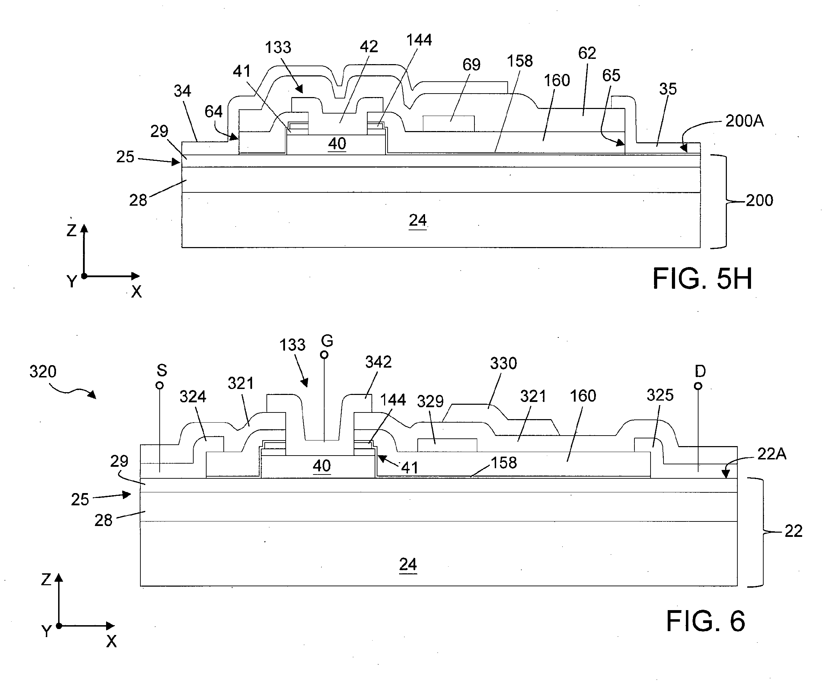

In Figure 5H, the work passivation layer 212 and the first and the second work insulating layers 213, 218 are patterned by lithography and etching steps, thus forming the passivation layer 158 and the first and the second insulating layers 160, 62 with the respective openings 64, 65.

The source region 34 and the drain region 35 are formed in the opening 64 and, respectively, 65.

Following final manufacturing steps, here not shown and known per se, for example dicing of the work body 200 and formation of electrical connections, the HEMT device 120 is obtained.

It will be clear to the person skilled in the art that the manufacturing process described with reference ' to Figures 5A-5H may be adapted to also manufacture the HEMT device 20 of Figure 1, for example by neglecting the steps relating to forming the second gate contact region 144.

Differently to what is shown in Figures 5A-5H, wherein the present HEMT device is manufactured according to a gate-first approach (gate structure 33, 133 formed before, the source and drain regions 34, 35), the present HEMT device may be manufactured according to an ohmic-first approach, wherein the source and drain regions are formed before the gate structure. In this manner, it is possible to use thermal processes while forming the source and drain regions which allow the contact resistance between the source and drain regions and the 2-dimensional gas to be lowered.

Figure 6 shows an embodiment of the present HEMT device, here indicated by 320, manufactured according to the ohmic-first approach. The HEMT device 320 has a general structure similar to that of the HEMT devices 20, 120; consequently, elements in common are identified by the same reference numerals and are not described in detail.

In the HEMT device 320, the second insulating layer, here indicated by 321, extends on the source and drain regions, here indicated by 324 and 325, respectively.

The first gate contact region, here indicated by 342, extends also through the second insulating layer 321.

The field plate region, here indicated by 329, extends between the first and the second insulating layers 160, 321, laterally to the gate structure 133, and may be formed together with the source and drain regions 324, 325.

The HEMT device 320 also comprises a shield conductive region 330 which partially extends on the second insulating layer 321 and works as an electromagnetic shield. The shield conductive region 330 extends, at a distance, partially or completely, here partially, above the field. plate region 330.

Finally, it is clear that modifications and variations may be made to the HEMT devices 20, 120 and the manufacturing processes thereof described and illustrated herein without thereby departing from the scope of the present invention, as defined in the attached claims.

For example, with reference to the HEMT device 20, the functional region 41 may extend only on one side of the gate contact region 42, for example on the source-side (on the left) or on the drain-side (on the right) of the gate contact region 42. In practice, the functional region 41 may have only one of the portions 50.

Similar considerations may also apply to the HEMT devices 120, 220.

For example, the portions 50 of the functional region 41 may only extend on part of the peripheral portions 46 of the channel modulating region 40.

For example, the outer walls 52 of the functional region 41 may not be aligned, along the third axis Z, with the lateral sidewalls 47 of the channel modulating region 40.

For example, the value Wₘ+2·W_{f} may be smaller than the width W_{g} of the channel modulating region 40, for example if further regions, for example of insulating material, are arranged directly on the top surface 40A of the channel modulating region 40.

The source region 34, 324, the drain region 35, 325 and the gate structure 33, 133 may extend along the second axis Y according to different shapes and configurations, according to the specific application, in a manner known per se and therefore not discussed in detail. For example, in top-plan view, not shown here, they may have the shape of strips elongated along the second axis Y, or may have a circular shape or any other shape, regular or non-regular.

For example, the channel layer 28 and the barrier layer 29 may each be formed by a plurality of layers overlying on each other, for example one or more GaN layers, or GaN-based alloys, suitably doped or of intrinsic-type, according to the specific application.

For example, the body 22 of the HEMT device may also comprise one or more insulating layers, for example of oxide or nitride, extending between the substrate 24 and the heterostructure 25, over the heterostructure 25, within the substrate 24, and/or within the heterostructure 25, according to the specific application or specific manufacturing process used.

For example, the body 22 may comprise a cap layer, for example of aluminum nitride (AlN), extending on and in contact with the barrier layer 29, i.e. forming the surface 22A.

For example, the body 22 may comprise a spacer layer, for example of AlN, between the channel layer 28 and the barrier layer 29.

For example, the present HEMT device may comprise a stack of overlying layers extending between the substrate 24 and the heterostructure 25, for example including' a buffer layer and a hole supply layer, in a per se known manner.

For example, the present HEMT device may be of the normally-on type.

Finally, the different embodiments described above may be combined so as to provide further solutions.

## Claims

1. A HEMT device (20; 120; 320) comprising:
a body (22) having a top surface (22A) and including a heterostructure (25) configured to generate a 2-dimensional charge-carrier gas (30, 49); and
a gate structure (33; 133) extending on the top surface of the body and biasable to electrically control the 2-dimensional charge-carrier gas,
the gate structure comprising a channel modulating region (40) of semiconductor material and having a top surface (40A); a functional region (41) of semiconductor material; and a gate contact region (42; 342) of conductive material,
wherein the functional region (41) and the gate contact region (42; 342) extend on the top surface (40A) of the channel modulating region and wherein the gate contact region is arranged laterally with respect to the functional region,
the channel modulating region (40) having a different conductivity type with respect to the functional region (41) or being intrinsic.

2. The HEMT device according to the preceding claim, wherein the channel modulating region (40) has a peripheral portion (46) forming a lateral sidewall (47) of the channel modulating region, the functional region (41) extending, at least in part, on the peripheral portion.

3. The HEMT device according to the preceding claim, wherein the functional region (41) has an outer wall (52) contiguous to the lateral sidewall of the channel modulating region.

4. The HEMT device according to any of the preceding claims, wherein the functional region (41) is of intrinsic-type.

5. The HEMT device according to any of claims 1-3, wherein the channel modulating region (40) has a first conductivity type (P) and the functional region (41) has a second conductivity type (N) opposite to the first conductivity type.

6. The HEMT device according to the preceding claim, wherein the functional region has a concentration of doping species lower than 10¹⁵ atoms/cm³.

7. The HEMT device according to any of the preceding claims, wherein the functional region (41) has an inner wall (51) in contact with the gate contact region (42; 342).

8. The HEMT device according to any of the preceding claims, wherein the functional region (41) has a width (W_{f}), along a first direction (X), and the gate contact region (42; 342) has a width (Wₘ), along the first direction, which is greater than the width of the functional region.

9. The HEMT device (120; 320) according to any of the preceding claims, wherein the gate contact region is a first gate contact region (42; 342), the gate structure (133) further comprising a second gate contact region (144) of conductive material extending, at least in part, on the functional region (41) and being in contact with the first gate contact region, in particular on a side of the first gate contact region.

10. The HEMT device according to the preceding claim, wherein the second gate contact region (144) is of a material chosen among Ti, Ta, TiN and TaN.

11. The HEMT device according to any of the preceding claims, further comprising an insulating region (58, 60; 158, 160) of non-conductive material extending on a lateral sidewall (47) of the channel modulating region (40) and on an outer wall (52) of the functional region (41) and extending, at least in part, on and at a distance with respect to the top surface of the channel modulating region (40) .

12. A process for manufacturing a HEMT device, comprising:
forming, on a top surface (200A) of a work body (200) including a heterostructure (25), a gate structure (33; 133), wherein the heterostructure is configured to generate a 2-dimensional charge-carrier gas (30, 49), and the gate structure is biasable to electrically control the 2-dimensional charge-carrier gas,
wherein forming a gate structure comprises:
forming a channel modulating region (40) having a top surface (40A), starting from a first semiconductor layer (202);
forming a functional region (41) on the top surface of the channel modulating region, starting from a second semiconductor layer (203); and
forming a gate contact region (42; 342) of conductive material extending on the top surface of the channel modulating region, laterally with respect to the functional region,
wherein the channel modulating region (40) has a different conductivity type with respect to the functional region (41).

13. The manufacturing process according to the preceding claim, comprising:
depositing the first semiconductor layer (202) on the top surface of the work body;
depositing the second semiconductor layer (203) on the first semiconductor layer;
patterning the first and the second semiconductor layers;
depositing at least one insulating layer (58, 60; 158, 160) of non-conductive material on a lateral sidewall (47) of the patterned first semiconductor layer, on an outer wall (52) of the patterned second semiconductor layer and, at least in part, over and at a distance with respect to the top surface of the first semiconductor layer;
wherein forming the gate contact region comprises:
forming an opening (215) exposing a portion of the patterned first semiconductor layer, the opening extending through the at least one insulating layer and the second semiconductor layer; and
depositing conductive material within the opening.

14. The manufacturing process according to claim 12 or 13, wherein the gate contact region is a first gate contact region, wherein forming a gate structure further comprises forming a second gate contact region (144) extending, at least in part, on the functional region (41) and in contact with the first gate contact region,
wherein forming a second gate contact region comprises:
forming at least one contact layer of conductive material on the second semiconductor layer (203);
performing an annealing configured to promote the formation of an ohmic contact between the at least one contact layer and the second semiconductor layer; and
removing a portion of the at least one contact layer over the second semiconductor layer, in particular where it is intended to form the first gate contact region.

15. The manufacturing process according to any of claims 12-14, further comprising forming at least one current conducting region (34, 35; 324, 325), of conductive material, in contact with the heterostructure (25), the step of forming the gate structure (33; 133) being performed before or after forming the at least one current conducting region.
